# EUROPEAN PATENT APPLICATION

(11) **EP 4 564 298 A1**
(43) Date of publication of application: **04.06.2025**
(21) Application number: 24203079.9
(22) Date of filing: 27.09.2024
(51) Int. Cl.: G06T 9/00, H04N 19/85

(54) **REDUCED DATA TRANSMISSION IN EDGE COMMUNICATION USING SNN BASED LOSSLESS DATA COMPRESSION WITH FASTER RECONSTRUCTION**

(30) Priority: 28.11.2023 IN 202321080648
(71) Applicant: Tata Consultancy Services Limited, Maharashtra (IN)
(72) Inventor: DEY, Sounak, 700160 Kolkata (IN); KADWAY, Chetan Sudhakar, 700160 Kolkata (IN); KAHALI, Sayan, 700160 Kolkata (IN); MUKHERJEE, Arijit, 700160 Kolkata (IN); PAL, Arpan, 700160 Kolkata (IN); SURI, Manan, 110016 New Delhi (IN)
(74) Representative: Goddar, Heinz J.

(57) **Abstract**

State of the art techniques for reduced data transmission at edge devices while using lossless compression mostly rely on CNNs that are energy consuming networks. However, for edge devices such as LEO satellites the method and system discloses a unique combination of SNN running on a neuromorphic platform for low-power & low-latency. Relevant data of high-resolution images is filtered, and redundant data is discarded. The filtered data is then compressed using but packing based lossless compression before transmitting to a central station for further processing. At the central station a distributed Diagonal Parallel Fast Reconstruction (DDPFR) is applied to reconstruct the image. The system reduces data sent to the central station and reduces battery consumption of satellite for data transmission. SNN running on neuromorphic processor consumes up to 100 to 1000x less power compared to similar Artificial neural network running on GPU.

## Description

### CROSS REFERENCE TO RELATED APPLICATIONS AND PRIORITY

The present application claims priority from Indian patent application no. 202321080648, filed on 28 November 2023.

### TECHNICAL FIELD

The embodiments herein generally relate to the field of low power edge communication and, more particularly, to a method and system for reduced data transmission in edge communication using Spiking Neural Network (SNN) based lossless data compression with faster reconstruction.

### BACKGROUND

Edge computing is becoming a preferred choice of Artificial Intelligence (AI) or Machine Learning (ML) model deployment, as it reduces the cost of running expensive Graphics Processing Unit (GPU) servers in the cloud. Along with reduced server cost, it helps with protecting users' data privacy. At present, there are various research paths being explored by AI researchers to design algorithms and hardware to quickly and efficiently build optimized TinyMI, models. Some of the techniques include: i) Efficient Inference practices such as quantization and factorization to lessen the intensity of computations needed for the arithmetic operations (matrix multiplication) that are fundamental to deep learning, ii) Designing smaller model architectures using architecture search techniques to reduce overall footprint of training and inference, iii) selecting efficient Deep learning (DL) model, such as sparse models and pruned models. When effectively done, this can maintain performance while reducing computation by 3x-10x, and iv) use of AI accelerators power and latency optimized for training and inference, over general-purpose processors, which can improve energy efficiency by 100x-1000x (e.g. Spiking Neural Networks running on Neuromorphic processors).

AI accelerators such as neuromorphic platforms are well researched for edge devices as they have characteristically low power consumption. However, refining of the processes that use neuromorphic platforms running Spiking Neural Networks (SNNs) needs to be explored for further reduction in power consumption on edge devices.

### SUMMARY

Embodiments of the present disclosure present technological improvements as solutions to one or more of the above-mentioned technical problems recognized by the inventors in conventional systems.

For example, in one embodiment, a method for reduced data transmission in edge communication is provided. The method comprising filtering a plurality of high-resolution images, by a Spiking Neural Network (SNN) running on a neuromorphic edge hardware, from among a stream of high-resolution images captured by an edge device for performing image compression, wherein the plurality of high-resolution images are at least one of clean images with no cloud cover, and images with cloud cover below a predefined cover threshold.

Further the method includes applying, by the SNN, a lossless compression technique on each of the filtered plurality of high-resolution images, the lossless compression technique applied on a high-resolution image from among the filtered plurality of high-resolution images to generate a lossless compressed image comprising: splitting the high-resolution image into a grid comprising a plurality of grids in accordance with a predefined grid size; identifying a row-column number of each of a set of boundary pixels of each of the plurality of patches based on image resolution and the grid size; building a first data packet for the high-resolution image comprising the set of boundary pixels and associated row-column number for each of the plurality of patches; extracting pixels of each of the plurality of image patches by excluding the set of boundary pixels to generate an input batch per patch in the grid; running in parallel a SNN prediction for each of the plurality of image patches using the input batch per patch on a first set of CPU cores deployed on the neuromorphic edge hardware of the edge device to generate predicted SNN data values from each CPU core for the high-resolution image; obtain a residual error for each of the plurality of image patches associated with each of the plurality of image grids based on difference between predicted SNN data vales and corresponding pixel values of the high-resolution image; generating a second data packet for the high-resolution image by applying bit-packing compression technique on the residual error obtained for each of the plurality of image patches; and generating a data packet pair comprising the first data packet and the second data packet representing the high-resolution image as the lossless compressed image.

Further, the method includes transmitting, by one or more hardware processors of the edge device, the data packet pair generated for each the plurality of high-resolution image to a central station, wherein the receiver applies a Distributed Diagonal Parallel Fast Reconstruction (DDPFR) technique to generate a lossless decompressed image from the lossless compressed image.

The DDPFR technique applied by the central station for each received lossless compressed image comprising: separating, via one or more hardware processors of the central station, the first data packet from the received data packet pair of the lossless compressed pair; extracting, via the one or more hardware processors of the central station, the residual error for each of the plurality of image patches by passing the second data packet received in the data packet pair in the lossless compressed image through a bit-packing decoder; distributing, via the one or more hardware processors of the central station, the set of boundary pixels and the residual error of each of the plurality of image patches on a second set of CPU cores at the receiver; running, via the one or more hardware processors of the central station, the SNN prediction from a top left corner of each of the plurality of image patches progressing from a first pixel of a first row to a last pixel of the first row; performing, via the one or more hardware processors of the central station, diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction; generating, via the one or more hardware processors of the central station, an input batch per patch comprising eligible pixels in each of the plurality of image patches; running, via the one or more hardware processors of the central station, the SNN prediction on the input batch per patch to generate predicted pixels for each of the plurality of image patches and adding associated residual error received in the second data packet to the predicted pixels; reconstructing, via the one or more hardware processors of the central station, each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image; and combining the reconstructed image patches from each of the second set of cores to obtain the lossless decompressed image.

In another aspect, a system for reduced data transmission in edge communication is provided. The system comprises an edge device in communication with a central station. The edge device comprising a memory storing instructions; one or more Input/Output (I/O) interfaces; and one or more hardware processors coupled to the memory via the one or more I/O interfaces, wherein the one or more hardware processors supported by a Spiking Neural Network (SNN) are configured by the instructions to filter a plurality of high-resolution images from among a stream of high-resolution images captured by an edge device for performing image compression, wherein the plurality of high-resolution images are at least one of clean images with no cloud cover, and images with cloud cover below a predefined cover threshold.

Further the SNN is configured to apply a lossless compression technique on each of the filtered plurality of high-resolution images, the lossless compression technique applied on a high-resolution image from among the filtered plurality of high-resolution images to generate a lossless compressed image comprising: splitting the high-resolution image into a grid comprising a plurality of grids in accordance with a predefined grid size; identifying a row-column number of each of a set of boundary pixels of each of the plurality of patches based on image resolution and the grid size; building a first data packet for the high-resolution image comprising the set of boundary pixels and associated row-column number for each of the plurality of patches; extracting pixels of each of the plurality of image patches by excluding the set of boundary pixels to generate an input batch per patch in the grid; running in parallel a SNN prediction for each of the plurality of image patches using the input batch per patch on a first set of CPU cores deployed on the neuromorphic edge hardware of the edge device to generate predicted SNN data values from each CPU core for the high-resolution image; obtain a residual error for each of the plurality of image patches associated with each of the plurality of image grids based on difference between predicted SNN data vales and corresponding pixel values of the high-resolution image; generating a second data packet for the high-resolution image by applying bit-packing compression technique on the residual error obtained for each of the plurality of image patches; and generating a data packet pair comprising the first data packet and the second data packet representing the high-resolution image as the lossless compressed image.

Further the edge device is configured to transmit the data packet pair generated for each the plurality of high-resolution image to a central station, wherein the receiver applies a Distributed Diagonal Parallel Fast Reconstruction (DDPFR) technique to generate a lossless decompressed image from the lossless compressed image.

The DDPFR technique applied by the central station for each received lossless compressed image comprising: separating, via one or more hardware processors of the central station, the first data packet from the received data packet pair of the lossless compressed pair; extracting, via the one or more hardware processors of the central station, the residual error for each of the plurality of image patches by passing the second data packet received in the data packet pair in the lossless compressed image through a bit-packing decoder; distributing, via the one or more hardware processors of the central station, the set of boundary pixels and the residual error of each of the plurality of image patches on a second set of CPU cores at the receiver; running, via the one or more hardware processors of the central station, the SNN prediction from a top left corner of each of the plurality of image patches progressing from a first pixel of a first row to a last pixel of the first row; performing, via the one or more hardware processors of the central station, diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction; generating, via the one or more hardware processors of the central station, an input batch per patch comprising eligible pixels in each of the plurality of image patches; running, via the one or more hardware processors of the central station, the SNN prediction on the input batch per patch to generate predicted pixels for each of the plurality of image patches and adding associated residual error received in the second data packet to the predicted pixels; reconstructing, via the one or more hardware processors of the central station, each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image; and combining the reconstructed image patches from each of the second set of cores to obtain the lossless decompressed image.

In yet another aspect, there are provided one or more non-transitory machine-readable information storage mediums comprising one or more instructions, which when executed by one or more hardware processors causes a method for reduced data transmission in edge communication.

The method comprising filtering a plurality of high-resolution images, by a Spiking Neural Network (SNN) running on a neuromorphic edge hardware, from among a stream of high-resolution images captured by an edge device for performing image compression, wherein the plurality of high-resolution images are at least one of clean images with no cloud cover, and images with cloud cover below a predefined cover threshold.

Further the method includes applying, by the SNN, a lossless compression technique on each of the filtered plurality of high-resolution images, the lossless compression technique applied on a high-resolution image from among the filtered plurality of high-resolution images to generate a lossless compressed image comprising: splitting the high-resolution image into a grid comprising a plurality of grids in accordance with a predefined grid size; identifying a row-column number of each of a set of boundary pixels of each of the plurality of patches based on image resolution and the grid size; building a first data packet for the high-resolution image comprising the set of boundary pixels and associated row-column number for each of the plurality of patches; extracting pixels of each of the plurality of image patches by excluding the set of boundary pixels to generate an input batch per patch in the grid; running in parallel a SNN prediction for each of the plurality of image patches using the input batch per patch on a first set of CPU cores deployed on the neuromorphic edge hardware of the edge device to generate predicted SNN data values from each CPU core for the high-resolution image; obtain a residual error for each of the plurality of image patches associated with each of the plurality of image grids based on difference between predicted SNN data vales and corresponding pixel values of the high-resolution image; generating a second data packet for the high-resolution image by applying bit-packing compression technique on the residual error obtained for each of the plurality of image patches; and generating a data packet pair comprising the first data packet and the second data packet representing the high-resolution image as the lossless compressed image.

Further, the method includes transmitting, by one or more hardware processors of the edge device, the data packet pair generated for each the plurality of high-resolution image to a central station, wherein the receiver applies a Distributed Diagonal Parallel Fast Reconstruction (DDPFR) technique to generate a lossless decompressed image from the lossless compressed image.

The DDPFR technique applied by the central station for each received lossless compressed image comprising: separating, via one or more hardware processors of the central station, the first data packet from the received data packet pair of the lossless compressed pair; extracting, via the one or more hardware processors of the central station, the residual error for each of the plurality of image patches by passing the second data packet received in the data packet pair in the lossless compressed image through a bit-packing decoder; distributing, via the one or more hardware processors of the central station, the set of boundary pixels and the residual error of each of the plurality of image patches on a second set of CPU cores at the receiver; running, via the one or more hardware processors of the central station, the SNN prediction from a top left corner of each of the plurality of image patches progressing from a first pixel of a first row to a last pixel of the first row; performing, via the one or more hardware processors of the central station, diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction; generating, via the one or more hardware processors of the central station, an input batch per patch comprising eligible pixels in each of the plurality of image patches; running, via the one or more hardware processors of the central station, the SNN prediction on the input batch per patch to generate predicted pixels for each of the plurality of image patches and adding associated residual error received in the second data packet to the predicted pixels; reconstructing, via the one or more hardware processors of the central station, each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image; and combining the reconstructed image patches from each of the second set of cores to obtain the lossless decompressed image.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1A is a high level architecture of a system, for reduced data transmission in edge communication using Spiking Neural Network (SNN) based lossless data compression with faster reconstruction, in accordance with some embodiments of the present disclosure.
FIG. 1B illustrates a process overview of the system of FIG. 1A at edge device end and central station end, in accordance with some embodiments of the present disclosure.
FIG. 2 is a functional block diagram of the edge device depicted in the system of FIG. 1A and 1B, in accordance with some embodiments of the present disclosure.
FIG. 3 is a functional block diagram of the central station depicted in the system of FIG. 1A and 1B, in accordance with some embodiments of the present disclosure.
FIGS. 4A through 4C (collectively referred as FIG. 4) is a flow diagram illustrating a method for reduced data transmission in edge communication using Spiking Neural Network (SNN) based lossless data compression with faster reconstruction, using the system depicted in FIG. 1A and 1B, in accordance with some embodiments of the present disclosure.
FIG. 5 depicts decompression applied by a Distributed Diagonal Parallel Fast reconstruction (DDPFR) technique on a lossless compressed image received by the central station of the system of FIG. 1A and 1B, in accordance with some embodiments of the present disclosure.

It should be appreciated by those skilled in the art that any block diagrams herein represent conceptual views of illustrative systems and devices embodying the principles of the present subject matter. Similarly, it will be appreciated that any flow charts, flow diagrams, and the like represent various processes which may be substantially represented in computer readable medium and so executed by a computer or processor, whether or not such computer or processor is explicitly shown.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Satellites, specifically Low Earth orbit (LEO satellites) are typical examples of an edge device, that demand for exploring techniques reducing power consumption at the satellite end. These satellites capture high-resolution images, thus reducing irrelevant data storage and reducing volume of data transmission to ground stations (in general referred to as central stations) is a major factor towards managing power consumed by the satellites (edge devices).

Applicant's Indian application no. 202121052643, *titled `Energy efficient hierarchical multi-stage Spiking Neural Network (SNN) architecture for classification and* segmentation *of high-resolution images' filed at IPO on 16 November 2021* proposes techniques to select relevant data and discard irrelevant data and is a *first* step in reducing data to be transmitted. Further to this applicant's another Indian Patent Application *titled 'Method and System for Low power lossless image compression using a spiking neural network', filed at IPO and* claiming priority from Indian provisional patent application number 202321040920, filed on June 15, 2023, provides and efficient but lossless compression. However, the above patent application uses Arithmetic coding. Similarly, other existing lossless compression techniques use and Lempel-Ziv-Welch (LZW) algorithms. However, Arithmetic encoding and LZW require maintaining dynamic dictionaries. This dynamic dictionary management leads to overhead in case of Arithmetic encoding and LZW, finally add up processing time for compression along with additional power consumption.

Thus, more efficient approaches are being explores to provide low power less time-consuming approaches for handling high volume of data transmission at edge devices.

Embodiments of the present disclosure addresses the low power, less time consuming requirement for edge devices by providing a method and system for reduced data transmission in edge communication using Spiking Neural Network (SNN) based lossless data compression with faster reconstruction.

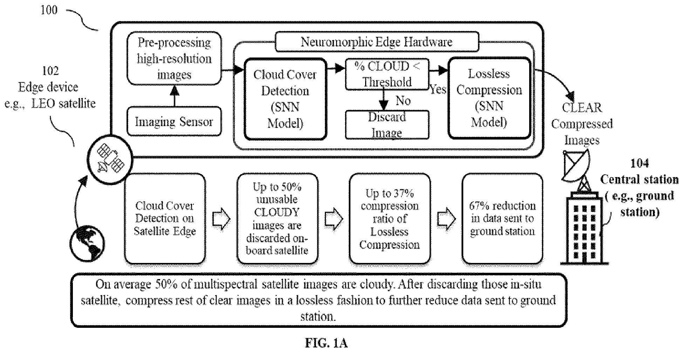

Referring now to the drawings, and more particularly to FIGS. 1A through 5, where similar reference characters denote corresponding features consistently throughout the figures, there are shown preferred embodiments, and these embodiments are described in the context of the following exemplary system and/or method.

FIG. 1A is a high level architecture of a system 100, for reduced data transmission in edge communication using Spiking Neural Network (SNN) based lossless data compression with faster reconstruction, in accordance with some embodiments of the present disclosure.

The system 100 disclosed comprises an edge device 102 such as the LEO satellite transmitting data to a central station 104, typically the ground station. The system 100 disclosed is based on the SNN running on a neuromorphic edge hardware on the edge device that is capable of filtering relevant data to be transmitted by discarding redundant, non-relevant data using the method as proposed in Applicant's Indian application no. 202121052643, *titled 'Energy efficient hierarchical multi-stage Spiking Neural Network (SNN) architecture for classification and* segmentation *of high-resolution images'.* The relevant data to be transmitted is further compressed using a unique bit-packing based lossless compression technique that is an enhanced technique over applicant's another Indian Patent Application Number 202321040920 *titled 'Method and System for Low power lossless image compression using a spiking neural network.* Unlike the arithmetic encoding bit packing is relatively easy to implement and does not use any complex mathematical operations. Consequently, this process leads to faster encoding and decoding. Bit packing or bit-width reduction is a lossless data compression method to reduce the number of bits required to represent data without incurring any loss of information. The key idea is to allocate fewer bits for the frequently occurring values while more bits is used to allocate to the less frequent values. This method mainly useful while dealing with the values that do not fully utilize the available bit space. Unlike Arithmetic encoding and LZW, bit packing does not require maintaining dynamic dictionaries. This dynamic dictionary management leads to overhead in case of Arithmetic encoding and LZW.

Even though bit packing is a known approach, the lossless compression with SNNs used for bit-packing that provides low power low latency processing for lossless compression is hardly explored in the art but is critical factor for edge computing.

Bit packing may not be the go-to solution for all edge device or high-resolution image compression scenarios, with careful consideration of the specific constraints it can be applied to practical applications. More importantly, the suitability of bit packing primarily depends on the specific characteristics and requirements of the application or system. For example, in scenarios as in the method and system herein, where the focus is on simplicity, low computational overhead, or specific data patterns, bit packing might become a viable option. Moreover, bit packing techniques become more practical if it is used within an architecture designed for low power consumption.

Thus, at sender end ( edge device end), the high-resolution image is partitioned in grid of patches and a payload that contains two things for each image: boundary pixel for each patch and bit-packing compressed residual error for each patch is transmitted. A compressed data is transmitted to the central station, which then applies a Distributed Diagonal Parallel Fast Reconstruction (DDPFR) technique to generate a lossless decompressed image from the lossless compressed image. At the central station end, which does not have major challenge of power constraints, the DDPFR can be executed on SNN running on the CPU/GPU platform. The DDPFR enables parallel reconstruction and refers to the technique of reconstructing or processing data using multiple parallel threads, processes. It has several advantages over sequential reconstruction: Parallel reconstruction significantly reduces the processing time by means of utilizing multiple computing resources concurrently. With the advent of multithreaded and multicore processors it is a natural fit. It helps achieve high throughput by processing multiple data items in parallel. Parallel systems can be designed with redundancy and fault tolerance, ensuring that if one unit fails, the others can continue the reconstruction process. This is crucial in mission-critical applications. Parallel processing can lead to energy savings by completing tasks faster, hardware can be idled or put into lower power states sooner.

Thus, at receiver end, the border pixels & compressed error for each patch is distributed on separate CPU core. Then on each CPU core (accompanied by co-processor like GPU) diagonal SNN prediction + decompressed residual addition is performed to get back the uncompressed high-res image.

On an average 50% of multispectral satellite images (high-resolution images) are cloudy. Thus, after discarding those in-situ the satellite, rest of clear images are compressed by the edge device 102 ( satellite) in a lossless fashion to further reduce data sent to ground station (central station 104).

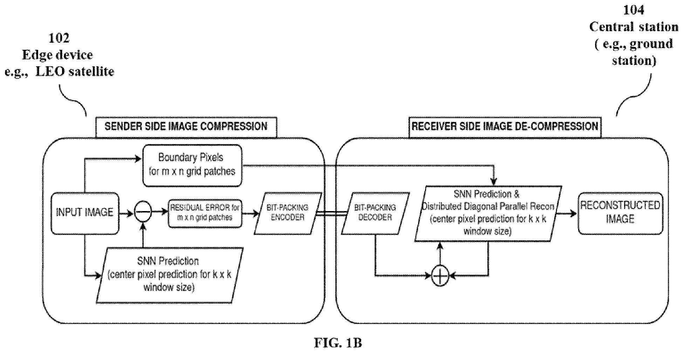

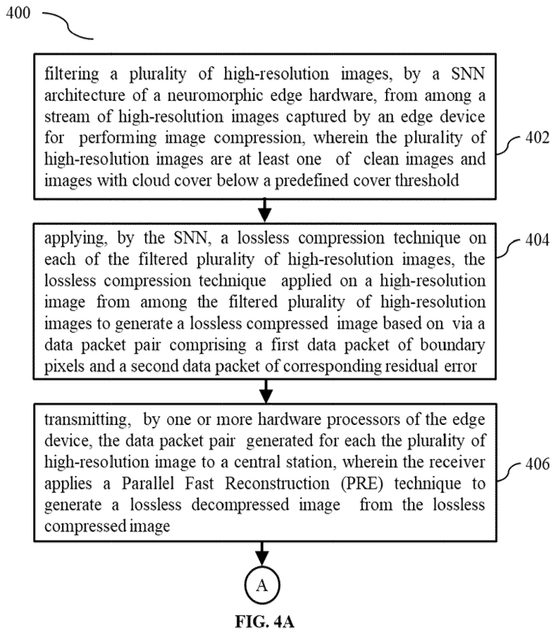

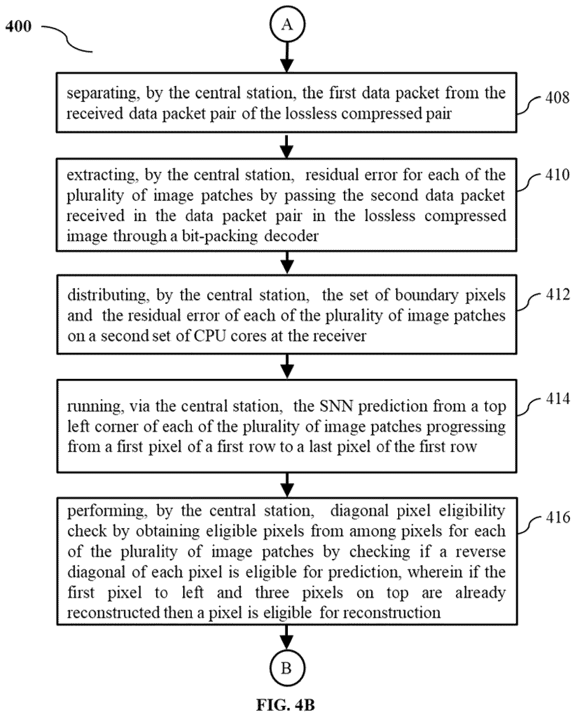

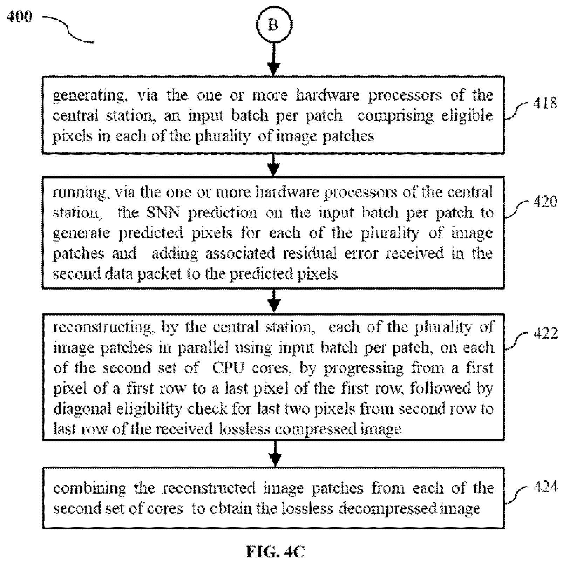

FIG. 1B illustrates a process overview of the system of FIG. 1A at edge device end and central station end, in accordance with some embodiments of the present disclosure. The FIG. 1B is explained later in conjunction with the flow diagram of FIG. 4.

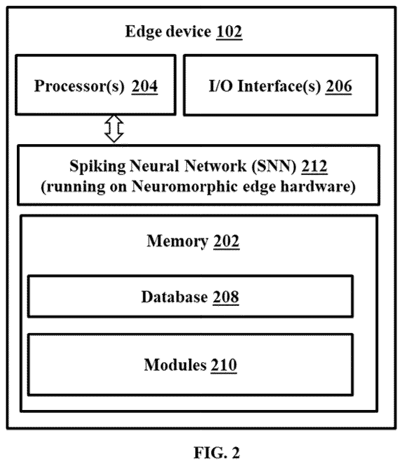

FIG. 2 is a functional block diagram of the edge device 102 depicted in the system of FIG. 1A and 1B, in accordance with some embodiments of the present disclosure.

In an embodiment, the edge device 102 includes a processor(s) 204, communication interface device(s), alternatively referred as input/output (I/O) interface(s) 206, and one or more data storage devices or a memory 202 operatively coupled to the processor(s) 204. The edge device 102 with one or more hardware processors 204 are supported by accelerator such as the SNN 212, running on a neuromorphic platform, and are configured to execute functions of one or more functional blocks of the edge device 102.

Referring to the components of edge device 102, in an embodiment, the processor(s) 204, can be one or more hardware processors 204. In an embodiment, the one or more hardware processors 204 can be implemented as one or more microprocessors, microcomputers, microcontrollers, digital signal processors, central processing units, state machines, logic circuitries, and/or any devices that manipulate signals based on operational instructions. In another embodiment the one or more hardware processors 204 can be implemented as processing units specific to edge hardware that can be used together with SNN. Among other capabilities, the one or more hardware processors 204 assisted by accelerators implemented using SNN architecture 212, running on a neuromorphic platform, and are configured to fetch and execute computer-readable instructions stored in the memory 202. In an embodiment, the edge device can be implemented in a variety of computing systems including laptop computers, notebooks, hand-held devices such as mobile phones, workstations, and the like.

The I/O interface(s) 206 can include a variety of software and hardware interfaces, for example, a web interface, a graphical user interface and the like and can facilitate multiple communications within a wide variety of networks N/W and protocol types, including wired networks, for example, LAN, cable, etc., and wireless networks, such as WLAN, cellular and the like. In an embodiment, the I/O interface (s) 206 can include one or more ports for connecting to a number of external devices or to another server or devices such as the central station 104.

The memory 202 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes.

In an embodiment, the memory 202 includes a plurality of modules 210. The plurality of modules 210 include programs or coded instructions that supplement applications or functions performed by the edge device 102 for executing one or more steps involved in the process of generating and transmitting the low compressed images. The plurality of modules 210, amongst other things, can include routines, programs, objects, components, and data structures, which perform particular tasks or implement particular abstract data types. The plurality of modules 210 may also be used as, signal processor(s), node machine(s), logic circuitries, and/or any other device or component that manipulates signals based on operational instructions. Further, the plurality of modules 210 can be used by hardware, by computer-readable instructions executed by the one or more hardware processors 104, or by a combination thereof. The plurality of modules 210 can include various sub-modules (not shown).

Before being fed to the SNN 212 for filtering, image capturing and preprocessing is performed on the high-resolution images by the processors 204, which is component of a Central Processing Unit (CPU). The highly computational task is accelerated with use of the SNN 212, wherein the SNN specifically accelerates the processing of high resolution images captured by the edge device 102. Image capturing devices such as satellite cameras and the like are installed on the edge devices for image capture. The SNN 212, when deployed in a LEO satellite, specifically enables high speed low power image filtering of images to identify relevant data to be transmitted. Further, this filtered data is compressed using the SNN 212 based on the bit-packing concept known in the art.

Bit packing or bit-width reduction is a lossless data compression technique to reduce the number of bits required to represent data without incurring any loss of information. The key idea is to allocate fewer bits for the frequently occurring values while more bits is used to allocate to the less frequent values. This method is mainly useful while dealing with the values that don't fully utilize the available bit space.

Bit packing concept:
Step 1: Data Representation: In bit packing, a sequence of data values to be compressed can be represented as a binary number.
Step 2: Frequency Analysis: Frequency analysis on the data values to determine how often each value appears. Values that occur more frequently are candidates for more efficient bit representation.
Step 3: Bit-Length Assignment: A specific bit length is assigned to each unique data value based on its frequency. Usually values that occur more frequently are assigned shorter bit lengths, and values that occur less frequently are assigned longer bit lengths.
Step 4: Bit Packing: Each data is then converted to its binary representation and pack them together, one after the other. The bit lengths of the values determine the number of bits used for each value.
Step 5. Decompression: The same process is reversed to decompress the data. The packed bits and the bit lengths are used together to reconstruct the original data values.

Further, the memory 202 may comprise information pertaining to input(s)/output(s) of each step performed by the processor(s) 104 of the system 100 and methods of the present disclosure.

Further, the memory 202 includes a database 208. The database (or repository) 108 may include a plurality of abstracted pieces of code for refinement and data that is processed, received, or generated as a result of the execution of the plurality of modules in the module(s) 210.

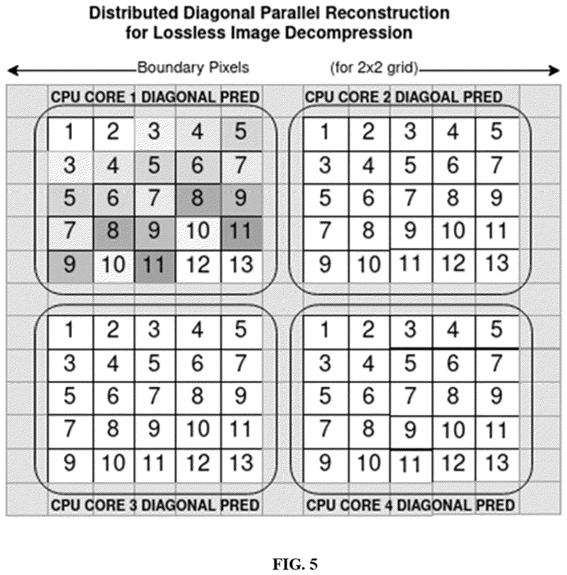

Although the data base 208 is shown internally to the edge device 102, it will be noted that, in alternate embodiments, the database 208 can also be implemented external to the system 100, and communicatively coupled to the edge device 102. The data contained within such an external database may be periodically updated. For example, new data may be added into the database (not shown in FIG. 1A) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the edge device 102 are now explained with reference to steps in flow diagrams in FIG. 4 and FIG. 5.

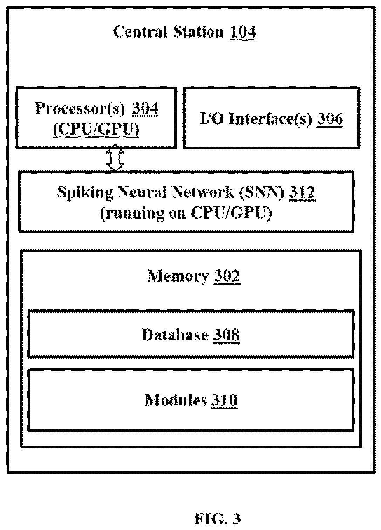

FIG. 3 is a functional block diagram of the central station 104 depicted in the system 100 of FIG. 1A and 1B, in accordance with some embodiments of the present disclosure.

In an embodiment, the central station 104 includes a processor(s) 304, communication interface device(s), alternatively referred as input/output (I/O) interface(s) 306, and one or more data storage devices or a memory 302 operatively coupled to the processor(s) 304. The central station 104 with one or more hardware processors 304 are supported by accelerators such as the SNN 312, running on a CPU/GPU platform, are configured to execute functions of one or more functional blocks of the central station 104.

Referring to the components of central station 104 , in an embodiment, the processor(s) 304, can be one or more hardware processors 304. In an embodiment, the one or more hardware processors 304 can be implemented as one or more microprocessors, microcomputers, microcontrollers, digital signal processors, central processing units, state machines, logic circuitries, and/or any devices that manipulate signals based on operational instructions. Among other capabilities, the one or more hardware processors 304 assisted by accelerators implemented using SNN 312, running on the CPU, and are configured to fetch and execute computer-readable instructions stored in the memory 302. In an embodiment, the central station can be implemented in a variety of computing systems including laptop computers, notebooks, hand-held devices such as mobile phones, workstations, mainframe computers, servers, and the like.

The I/O interface(s) 306 can include a variety of software and hardware interfaces, for example, a web interface, a graphical user interface and the like and can facilitate multiple communications within a wide variety of networks N/W and protocol types, including wired networks, for example, LAN, cable, etc., and wireless networks, such as WLAN, cellular and the like. In an embodiment, the I/O interface (s) 306 can include one or more ports for connecting to a number of external devices or to another server or devices such as the edge device 102.

The memory 302 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 302 includes a plurality of modules 310. The plurality of modules 310 include programs or coded instructions that supplement applications or functions performed by the central station 104 for executing one or more steps involved in the process of generating and transmitting the low compressed images. The plurality of modules 310, amongst other things, can include routines, programs, objects, components, and data structures, which performs particular tasks or implement particular abstract data types. The plurality of modules 310 may also be used as, signal processor(s), node machine(s), logic circuitries, and/or any other device or component that manipulates signals based on operational instructions. Further, the plurality of modules 310 can be used by hardware, by computer-readable instructions executed by the one or more hardware processors 104, or by a combination thereof. The plurality of modules 310 can include various sub-modules (not shown).

Image decompression and reconstruction is performed by the SNN 312. The highly computational task is accelerated with use of the SNN 312. The compression process applied by the edge device 102 is reversed to decompress the data. The packed bits and the bit lengths are used together to reconstruct the original data values.

Further, the memory 302 may comprise information pertaining to input(s)/output(s) of each step performed by the processor(s) 104 of the system 100 and methods of the present disclosure.

Further, the memory 302 includes a database 308. The database (or repository) 108 may include a plurality of abstracted pieces of code for refinement and data that is processed, received, or generated as a result of the execution of the plurality of modules in the module(s) 310.

Although the data base 308 is shown internally to the central station 104 it will be noted that, in alternate embodiments, the database 308 can also be implemented external to the system 100, and communicatively coupled to the central station 104 . The data contained within such an external database may be periodically updated. For example, new data may be added into the database (not shown in FIG. 1A) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the central station 104 are now explained with reference to steps in flow diagrams in FIG. 4 and FIG. 5.

FIGS. 4A through 4C (collectively referred as FIG.42) is a flow diagram illustrating a method 400 for reduced data transmission in edge communication using Spiking Neural Network (SNN) based lossless data compression with faster reconstruction, using the system 100 depicted in FIG. 1A and 1B, in accordance with some embodiments of the present disclosure.

In an embodiment, the system 100 comprises the edge device 102 having one or more data storage devices or the memory 202 operatively coupled to the processor(s) 204 and the SNN 212 and is configured to store instructions for execution of steps of the method 400 by the processor(s) or one or more hardware processors 104 and the SNN 212. The steps 402 through 406 of the method 400 of the present disclosure will now be explained with reference to the components or blocks of the edge device 102 as depicted in FIG. 1A and 1B and the steps of flow diagram as depicted in FIG. 4. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practical. Further, some steps may be performed simultaneously.

The steps of the method 400 are understood with the understanding that a stream of high-resolution images is captured by image capturing device deployed on the edge device 102 and preprocessed by the one or more hardware processors 204. These preprocessed high resolution images are provided to the SNN 212 running on the neuromorphic edge hardware,. In an example implementation, the edge device is a LEO satellite capturing high-resolution images of the earth and the central station 104 is a ground station processing the received lossless compressed images to derive insights and respond with actions in accordance with the derived insight.

Referring to the method 400, at step 402 of the method 400, the SNN 212 is configured by the instructions to filter a plurality of high-resolution images from among a stream of high-resolution images captured by an edge device for performing image compression. The plurality of high-resolution images are at least one of clean images with no cloud cover, and images with cloud cover below a predefined cover threshold. As mentioned earlier, the filtering step 402 is carried out in accordance with the approach proposed in the applicant's Indian application no. 202121052643, titled `Energy efficient hierarchical multi-stage Spiking Neural Network (SNN) architecture for classification and segmentation of high-resolution images' filed at IPO on 16 November 2021and not explained in detail for brevity.

Upon receiving relevant data, at step 404 of the method 400, the SNN 212 is configured by the instructions to apply a lossless compression technique on each of the filtered plurality of high-resolution images.

The lossless compression technique applied on a high-resolution image from among the filtered plurality of high-resolution images to generate a lossless compressed image is based on applicant's another Indian Patent Application *titled 'Method and System for Low power lossless image compression using a spiking neural network', filed at IPO and* claiming priority from Indian provisional patent application number 202321040920, filed on June 15, 2023. However the arithmetic encoder is replaced with a bit-packing encoder in the system disclosed herein.

The steps below explain parallel SNN prediction for multiple grid patches on sender side ( edge device 102). It explains the sender side steps that help DDPFR work properly at the receiver end (central station 104) for image reconstruction.

Step 404a- Split the high-resolution image into a grid comprising a plurality of grids in accordance with a predefined grid size. Depending on the m x n grid each input high-resolution the image is cut into m-rows and n-columns. Thus, m-rows of floor(K/2) pixels height and n-columns of floor(K/2) pixels width is sent to receiver to be able to perform distributed diagonal parallel image reconstruction. The number of parallel processing units used at reconstruction end (central station 104) needs to be known at the sender side (edge device) indicating how many pieces the image is split and appropriate required data v can be sent to receiving end for parallel reconstruction to be possible.

Step 404b- Identify a row-column number of each of a set of boundary pixels of each of the plurality of patches based on image resolution and the grid size.

Step 404c- Build a first data packet for the high-resolution image comprising the set of boundary pixels and associated row-column number for each of the plurality of patches;

Step 404d- Extract pixels of each of the plurality of image patches by excluding the set of boundary pixels to generate an input batch per patch in the grid.

Step 404e- Run in parallel a SNN prediction for each of the plurality of image patches using the input batch per patch on a first set of CPU cores deployed on the neuromorphic edge hardware of the edge device to generate predicted SNN data values from each CPU core for the high-resolution image. The SNN prediction predicts the center pixel in a sliding window, if a neighboring pixel of center pixel is provided and generates an image comprising predicted pixels.

Step 404f- Obtain residual error for each of the plurality of image patches associated with each of the plurality of image grids based on difference between predicted SNN data values and corresponding pixel values of the high-resolution image. Thus, the SNN 212 subtracts the predicted pixel image from the original high-resolution image to obtain an error image (residual error) to understand how far the prediction was from the original value. Now, when such an error image (residual error capturing only the difference) is sent through bit-packing, it takes less space on storage compared to original image because the range of value that a pixel can take decreases). The lower the dynamic range of pixel error, the better the compression ratio.

Bit packing concept:
- Data Representation: In bit packing, a sequence of data values to be compressed can be represented as a binary number.
- Frequency Analysis: Frequency analysis on the data values to determine how often each value appears. Values that occur more frequently are candidates for more efficient bit representation.
- Bit-Length Assignment: A specific bit length is assigned to each unique data value based on its frequency. Usually values that occur more frequently are assigned shorter bit lengths, and values that occur less frequently are assigned longer bit lengths.

- Bit Packing: Each data is then converted to its binary representation and pack them together, one after the other. The bit lengths of the values determine the number of bits used for each value.
- Decompression: The same process is reversed to decompress the data. The packed bits and the bit lengths are used together to reconstruct the original data values.

Step 404g- Generate a second data packet for the high-resolution image by applying bit-packing compression technique (as explained in bit packing concept above) on the residual error obtained for each of the plurality of image patches.

Step 404h- Generate a data packet pair comprising the first data packet and the second data packet representing the high-resolution image as the lossless compressed image.

Once the compression is performed, then at step 406, the one or more hardware processors 204 are configured by the instructions to transmit the data packet pair generated for each the plurality of high-resolution image to a central station, wherein the receiver applies a Distributed Diagonal Parallel Fast Reconstruction (DDPFR) technique to generate a lossless decompressed image from the lossless compressed image.

Referring now to the central station that receives the compressed images, in an embodiment, the central station 104 has one or more data storage devices or the memory 302 operatively coupled to the processor(s) 304 and the SNN 312 and is configured to store instructions for execution of steps of the method 400 by the processor(s) or one or more hardware processors 304 and the SNN 312. The steps 408 through 426 of the method 400 of the present disclosure will now be explained with reference to the components or blocks of the central station 104 as depicted in FIG. 1A and 1B and the steps of flow diagram as depicted in FIG. 4. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practical. Further, some steps may be performed simultaneously.

Referring back to method 400, at step 408 through 424 the DDPFR technique is applied by the central station 104 for each received lossless compressed image.

Thus, at step 408 of the method 400, the one or more hardware processors 304 are configured by the instructions to separate the first data packet from the received data packet pair of the lossless compressed pair.

At step 410 of the method 400, the one or more hardware processors 304 are configured by the instructions to extract the residual error for each of the plurality of image patches by passing the second data packet received in the data packet pair in the lossless compressed image through a bit-packing decoder (unlike arithmetic decoder in applicant's another Indian Patent Application *titled 'Method and System for Low power lossless image compression using a spiking neural network', filed at IPO and* claiming priority from Indian provisional patent application number 202321040920, filed on June 15, 2023).

At step 412 of the method 400, the one or more hardware processors 304 are configured by the instructions to distribute the set of boundary pixels and the residual error of each of the plurality of image patches on a second set of CPU cores at the receiver.

At step 414 of the method 400, the one or more hardware processors 304 are configured by the instructions to run the SNN prediction via the SNN 312 from a top left corner of each of the plurality of image patches progressing from a first pixel of a first row to a last pixel of the first row.

At step 416 of the method 400, the one or more hardware processors 304 are configured by the instructions to diagonal pixel eligibility check by obtaining eligible pixels from among pixels for each of the plurality of image patches by checking if a reverse diagonal of each pixel is eligible for prediction. If the first pixel to left and three pixels on top are already reconstructed, then a pixel is eligible for reconstruction.

At step 418 of the method 400, the one or more hardware processors 304 are configured by the instructions to generate an input batch per patch comprising eligible pixels in each of the plurality of image patches.

At step 420 of the method 400, the one or more hardware processors 304 are configured by the instructions to run the SNN prediction on the input batch per patch to generate predicted pixels for each of the plurality of image patches and adding associated residual error received in the second data packet to the predicted pixels.

At step 422 of the method 400, the one or more hardware processors 304 are configured by the instructions to reconstruct each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image.

At step 424 of the method 400, the one or more hardware processors 304 are configured by the instructions to combine the reconstructed image patches from each of the second set of cores to obtain the lossless decompressed image.

FIG. 5 depicts decompression applied by a Distributed Diagonal Parallel Fast reconstruction (DDPFR) technique on a lossless compressed image received by the central station of the system of FIG. 1A and 1B, in accordance with some embodiments of the present disclosure. FIG. 5 shows the prediction order/sequence of the diagonal prediction approach. All boxes with the same number get predicted all at the same time.

Thus, it can be understood that state of the art techniques for reduced data transmission at edge devices with lossless compression mostly rely on Convolutional Neural Networks (CNNs) that are energy consuming networks. However, for edge devices such as LEO satellites the method and system discloses a unique combination of SNN running on a neuromorphic platform for low-power & low-latency. Relevant data of high-resolution images is filtered, and redundant data is discarded. The filtered data is then compressed using but packing based lossless compression before transmitting to a central station for further processing. At the central station a distributed Diagonal Parallel Fast Reconstruction (DDPFR) is applied to reconstruct the image. The system reduces data sent to the central station and reduces battery consumption of satellite for data transmission. SNN running on neuromorphic processor consumes up to 100 to 1000x less power compared to similar Artificial neural network running on GPU. Exact power & latency reduction depends on the use-case/application/task at hand.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (400) for data transmission in edge communication, the method comprising:
filtering a plurality of high-resolution images (402), by a Spiking Neural Network (SNN) running on a neuromorphic edge hardware, from among a stream of high-resolution images captured by an edge device for performing image compression, wherein the plurality of high-resolution images are at least one of clean images with no cloud cover, and images with cloud cover below a predefined cover threshold;
applying (404), by the SNN, a lossless compression technique on each of the filtered plurality of high-resolution images, the lossless compression technique applied on a high-resolution image from among the filtered plurality of high-resolution images to generate a lossless compressed image comprising:
splitting the high-resolution image into a grid comprising a plurality of grids in accordance with a predefined grid size;
identifying a row-column number of each of a set of boundary pixels of each of the plurality of patches based on image resolution and the grid size;
building a first data packet for the high-resolution image comprising the set of boundary pixels and associated row-column number for each of the plurality of patches;
extracting pixels of each of the plurality of image patches by excluding the set of boundary pixels to generate an input batch per patch in the grid;
running in parallel a SNN prediction for each of the plurality of image patches using the input batch per patch on a first set of CPU cores deployed on the neuromorphic edge hardware of the edge device to generate predicted SNN data values from each CPU core for the high-resolution image;
obtaining a residual error for each of the plurality of image patches associated with each of the plurality of image grids based on difference between predicted SNN data vales and corresponding pixel values of the high-resolution image;
generating a second data packet for the high-resolution image by applying bit-packing compression technique on the residual error obtained for each of the plurality of image patches; and
generating a data packet pair comprising the first data packet and the second data packet representing the high-resolution image as the lossless compressed image; and
transmitting (406), by one or more hardware processors of the edge device, the data packet pair generated for each of the plurality of high-resolution images to a central station, wherein the receiver applies a Distributed Diagonal Parallel Fast Reconstruction (DDPFR) technique to generate a lossless decompressed image from the lossless compressed image.

2. The processor implemented method as claimed in claim 1, wherein the DDPFR technique applied by the central station for each received lossless compressed image comprising:
separating, via one or more hardware processors of the central station, the first data packet from the received data packet pair of the lossless compressed pair (408);
extracting, via the one or more hardware processors of the central station, the residual error for each of the plurality of image patches by passing the second data packet received in the data packet pair in the lossless compressed image through a bit-packing decoder (410);
distributing, via the one or more hardware processors of the central station, the set of boundary pixels and the residual error of each of the plurality of image patches on a second set of CPU cores at the receiver (412);
running, via the one or more hardware processors of the central station, the SNN prediction from a top left corner of each of the plurality of image patches progressing from a first pixel of a first row to a last pixel of the first row (414);
performing, via the one or more hardware processors of the central station, diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction (416);
generating, via the one or more hardware processors of the central station, an input batch per patch comprising eligible pixels in each of the plurality of image patches(418);
running, via the one or more hardware processors of the central station, the SNN prediction on the input batch per patch to generate predicted pixels for each of the plurality of image patches and adding associated residual error received in the second data packet to the predicted pixels(420);
reconstructing, via the one or more hardware processors of the central station, each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image (422); and
combining the reconstructed image patches from each of the second set of cores to obtain the lossless decompressed image (424).

3. The processor implemented method as claimed in claim 1, wherein the stream of high-resolution images is captured by image capturing device deployed on the edge device and preprocessed by the one or more hardware processors of the edge device prior to filtering of the plurality of high-resolution images.

4. The processor implemented method as claimed in claim 1, wherein the edge device is a satellite capturing high-resolution images of the earth and the central station is a ground station processing the received lossless compressed images to derive insights and respond with actions in accordance with the derived insight.

5. A system (100) for data transmission in edge communication, the system (100) comprises:
an edge device (102) in communication with a central station (104), wherein
the edge device (102) comprises:
a memory (202) storing instructions;
one or more Input/Output (I/O) interfaces (206); and
one or more hardware processors (104) coupled to the memory (202) via the one or more I/O interfaces (206), wherein the one or more hardware processors (204) supported by a Spiking Neural Network (SNN) (212) running on a neuromorphic edge hardware are configured by the instructions to:
filter a plurality of high-resolution images, by the SNN (212), from among a stream of high-resolution images captured by an edge device for performing image compression, wherein the plurality of high-resolution images are at least one of clean images with no cloud cover, and images with cloud cover below a predefined cover threshold;
apply, by the SNN (212), a lossless compression technique on each of the filtered plurality of high-resolution images, the lossless compression technique applied on a high-resolution image from among the filtered plurality of high-resolution images to generate a lossless compressed image comprising:
splitting the high-resolution image into a grid comprising a plurality of grids in accordance with a predefined grid size;
identifying a row-column number of each of a set of boundary pixels of each of the plurality of patches based on image resolution and the grid size;
building a first data packet for the high-resolution image comprising the set of boundary pixels and associated row-column number for each of the plurality of patches;
extracting pixels of each of the plurality of image patches by excluding the set of boundary pixels to generate an input batch per patch in the grid;
running in parallel a SNN prediction for each of the plurality of image patches using the input batch per patch on a first set of CPU cores deployed on the neuromorphic edge hardware of the edge device to generate predicted SNN data values from each CPU core for the high-resolution image;
obtaining a residual error for each of the plurality of image patches associated with each of the plurality of image grids based on difference between predicted SNN data vales and corresponding pixel values of the high-resolution image;
generating a second data packet for the high-resolution image by applying bit-packing compression technique on the residual error obtained for each of the plurality of image patches; and
generating a data packet pair comprising the first data packet and the second data packet representing the high-resolution image as the lossless compressed image; and
transmit, by one or more hardware processors (204) of the edge device (102), the data packet pair generated for each the plurality of high-resolution image to a central station, wherein the receiver applies a Distributed Diagonal Parallel Fast Reconstruction (DDPFR) technique to generate a lossless decompressed image from the lossless compressed image.

6. The system (100) as claimed in claim 5, wherein the central station (104), comprises:
a memory (302) storing instructions;
one or more Input/Output (I/O) interfaces (306); and
one or more hardware processors (304) coupled to the memory (302) via the one or more I/O interfaces (306), wherein the one or more hardware processors (304) supported by a Spiking Neural Network (SNN) (312) running on the central station (104) are configured by the instructions to apply the DDPFR technique for each received lossless compressed image, the DDPFR technique comprising:
separating the first data packet from the received data packet pair of the lossless compressed pair;
extracting the residual error for each of the plurality of image patches by passing the second data packet received in the data packet pair in the lossless compressed image through a bit-packing decoder;
distributing the set of boundary pixels and the residual error of each of the plurality of image patches on a second set of CPU cores at the receiver;
running the SNN prediction from a top left corner of each of the plurality of image patches progressing from a first pixel of a first row to a last pixel of the first row;
performing diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction;
generating an input batch per patch comprising eligible pixels in each of the plurality of image patches;
running the SNN prediction on the input batch per patch to generate predicted pixels for each of the plurality of image patches and adding associated residual error received in the second data packet to the predicted pixels;
reconstructing, via the one or more hardware processors of the central station, each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image; and
combining the reconstructed image patches from each of the second set of cores to obtain the lossless decompressed image.

7. The system as claimed in claim 5, wherein the stream of high-resolution images is captured by image capturing device deployed on the edge device (102) and preprocessed by the one or more hardware processors (204) prior to filtering of the plurality of high-resolution images.

8. The system as claimed in claim 5, wherein the edge device (012) is a satellite capturing high-resolution images of the earth and the central station (104) is a ground station processing the received lossless compressed images to derive insights and respond with actions in accordance with the derived insight.

9. One or more non-transitory machine-readable information storage mediums comprising one or more instructions which when executed by one or more hardware processors cause:
filtering a plurality of high-resolution images, by a Spiking Neural Network (SNN) running on a neuromorphic edge hardware, from among a stream of high-resolution images captured by an edge device for performing image compression, wherein the plurality of high-resolution images are at least one of clean images with no cloud cover, and images with cloud cover below a predefined cover threshold;
applying, by the SNN, a lossless compression technique on each of the filtered plurality of high-resolution images, the lossless compression technique applied on a high-resolution image from among the filtered plurality of high-resolution images to generate a lossless compressed image comprising:
splitting the high-resolution image into a grid comprising a plurality of grids in accordance with a predefined grid size;
identifying a row-column number of each of a set of boundary pixels of each of the plurality of patches based on image resolution and the grid size;
building a first data packet for the high-resolution image comprising the set of boundary pixels and associated row-column number for each of the plurality of patches;
extracting pixels of each of the plurality of image patches by excluding the set of boundary pixels to generate an input batch per patch in the grid;
running in parallel a SNN prediction for each of the plurality of image patches using the input batch per patch on a first set of CPU cores deployed on the neuromorphic edge hardware of the edge device to generate predicted SNN data values from each CPU core for the high-resolution image;
obtaining a residual error for each of the plurality of image patches associated with each of the plurality of image grids based on difference between predicted SNN data vales and corresponding pixel values of the high-resolution image;
generating a second data packet for the high-resolution image by applying bit-packing compression technique on the residual error obtained for each of the plurality of image patches; and
generating a data packet pair comprising the first data packet and the second data packet representing the high-resolution image as the lossless compressed image; and
transmitting, by one or more hardware processors of the edge device, the data packet pair generated for each of the plurality of high-resolution images to a central station, wherein the receiver applies a Distributed Diagonal Parallel Fast Reconstruction (DDPFR) technique to generate a lossless decompressed image from the lossless compressed image.

10. The one or more non-transitory machine-readable information storage mediums as claimed in claim 9, wherein the DDPFR technique applied by the central station for each received lossless compressed image comprising:
separating the central station, the first data packet from the received data packet pair of the lossless compressed pair;
extracting the central station, the residual error for each of the plurality of image patches by passing the second data packet received in the data packet pair in the lossless compressed image through a bit-packing decoder;
distributing the set of boundary pixels and the residual error of each of the plurality of image patches on a second set of CPU cores at the receiver;
running the SNN prediction from a top left corner of each of the plurality of image patches progressing from a first pixel of a first row to a last pixel of the first row;
performing diagonal pixel eligibility check by obtaining eligible pixels from among pixels for each of the plurality of image patches by checking if a reverse diagonal of each pixel is eligible for prediction, wherein if the first pixel to left and three pixels on top are already reconstructed then a pixel is eligible for reconstruction;
generating, an input batch per patch comprising eligible pixels in each of the plurality of image patches;
running the SNN prediction on the input batch per patch to generate predicted pixels for each of the plurality of image patches and adding associated residual error received in the second data packet to the predicted pixels;
reconstructing each of the plurality of image patches in parallel using input batch per patch, on each of the second set of CPU cores, by progressing from a first pixel of a first row to a last pixel of the first row, followed by diagonal eligibility check for last two pixels from second row to last row of the received lossless compressed image; and
combining the reconstructed image patches from each of the second set of cores to obtain the lossless decompressed image.

11. The one or more non-transitory machine-readable information storage mediums as claimed in claim 9, wherein the stream of high-resolution images is captured by image capturing device deployed on the edge device and preprocessed by the one or more hardware processors of the edge device prior to filtering of the plurality of high-resolution images.

12. The one or more non-transitory machine-readable information storage mediums as claimed in claim 9, wherein the edge device is a satellite capturing high-resolution images of the earth and the central station is a ground station processing the received lossless compressed images to derive insights and respond with actions in accordance with the derived insight.
